# EUROPEAN PATENT APPLICATION

(11) **EP 4 725 708 A1**
(43) Date of publication of application: **15.04.2026**
(21) Application number: 25206789.7
(22) Date of filing: 06.10.2025
(51) Int. Cl.: B41J 2/18, B41J 29/377, B41J 29/38

(54) **INKJET RECORDING APPARATUS**

(30) Priority: 10.10.2024 JP 2024177877
(71) Applicant: KYOCERA Document Solutions Inc., Osaka-shi, Osaka 540-8585 (JP)
(72) Inventor: Tasaka, Shimon, Osaka-shi, 540-8585 (JP)
(74) Representative: Plougmann Vingtoft a/s

(57) **Abstract**

An inkjet recording apparatus (10) includes a cooling device (6), a current sensing device (88), and a determination device (8c). The cooling device (6) includes a centrifugal pump (64) and a motor (64a) that drives the centrifugal pump (64). The current sensing device (88) senses a current flowing to the motor (64a). The determination device (8c) determines whether or not air entrainment and liquid leakage occur in the circulation path in the cooling device (6) by comparing the current sensed by the current sensing device (88) and a current reference range.

## Description

### INCORPORATION BY REFERENCE

This application is based upon and claims the benefit of priority from the corresponding Japanese Patent Application No. 2024-177877 filed on October 10, 2024, the entire contents of which are incorporated herein by reference.

### BACKGROUND

This disclosure relates to an inkjet recording apparatus including a cooling device that cools an inkjet head.

An inkjet recording apparatus includes an inkjet head that ejects ink to a sheet. In a case where the inkjet head is continuously operating for a long time in the inkjet recording apparatus, the temperature of the inkjet head increases.

When the temperature of the inkjet head increases too much, the quality of a printed image is adversely influenced. It is therefore important to cool the inkjet head to optimal temperature.

For example, it has been known that the inkjet head includes a heat pump that cools air which cools the inkjet head.

### SUMMARY

An inkjet recording apparatus according to an aspect of this disclosure includes an inkjet head, a cooling device, a current sensing device, and a determination device. The inkjet head forms an image on a sheet by ejecting ink. The cooling device includes a centrifugal pump and a motor that drives the centrifugal pump. The cooling device cools the inkjet head by circulating a liquid refrigerant in a circulation path using the centrifugal pump. The circulation path extends through the inkjet head. The current sensing device senses a current flowing to the motor. The determination device determines whether or not air entrainment and liquid leakage occur in the circulation path in the cooling device by comparing the current sensed by the current sensing device and a current reference range.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 is a configuration diagram of an inkjet recording apparatus according to an embodiment.
FIG. 2 is a block diagram showing a configuration of a control device in the inkjet recording apparatus according to the embodiment.

### DETAILED DESCRIPTION

Hereinafter, an embodiment of this disclosure will be described with reference to the drawings. It is noted that the following embodiment is a specific example of this disclosure and does not limit the technical scope of this disclosure.

### [Configuration of Inkjet Recording Apparatus 10]

An inkjet recording apparatus 10 includes a sheet storing portion 12, a sheet conveying device 2, a printing device 3, and an ink supply device 4.

Furthermore, the inkjet recording apparatus 10 also includes an operation device 801, a display device 802, a control device 8, and the like.

The sheet conveying device 2, the printing device 3, the ink supply device 4, and the control device 8 are stored in a body 11 of the inkjet recording apparatus 10.

The sheet conveying device 2 conveys sheets 9 stored in the sheet storing portion 12 one by one along a sheet conveyance path 20. Furthermore, the sheet conveying device 2 feeds the sheets 9 on each of which an image is formed by the printing device 3 from the sheet conveyance path 20. For example, the sheet conveying device 2 feeds the sheets 9 from the sheet conveyance path 20 to a discharge tray or another subsequent device.

The sheet conveying device 2 includes a sheet feeding portion 21, a plurality of conveying roller pairs 22, a first belt conveyance unit 23, a second belt conveyance unit 24, a feeding roller pair 25, and the like. The sheet feeding portion 21 feeds the sheets 9 from the sheet storing portion 12 one by one to the sheet conveyance path 20.

The plurality of conveying roller pairs 22 succeeds the sheet feeding portion 21 in conveying the sheets 9 and conveys the sheets 9 toward the first belt conveyance unit 23.

The first belt conveyance unit 23 succeeds the plurality of conveying roller pairs 22 in conveying the sheets 9 and conveys the sheets 9 below the printing device 3. Furthermore, the first belt conveyance unit 23 feeds the sheets 9 to the second belt conveyance unit 24.

The second belt conveyance unit 24 succeeds the first belt conveyance unit 23 in conveying the sheets 9 and further feeds the sheets 9 to the feeding roller pair 25. It is noted that the inkjet recording apparatus 10 includes an unillustrated drying device in some cases. The drying device dries ink on each of the sheets 9 conveyed by the second belt conveyance unit 24.

The feeding roller pair 25 feeds the sheets 9 on each of which an image is formed to the outside of the body 11.

The printing device 3 executes a print process by ejecting ink to each of the sheets 9 conveyed by the first belt conveyance unit 23. The print process is a process of forming an image on each of the sheets 9.

The printing device 3 includes a plurality of inkjet heads 31 corresponding to a plurality of ink colors. Each of the inkjet heads 31 includes an ink ejection portion 31A including a plurality of nozzles that each ejects ink. The ink supply device 4 supplies the plurality of inkjet heads 31 with inks different from each other in color.

In this embodiment, the printing device 3 includes the four inkjet heads 31 corresponding to the four colors of black, cyan, magenta, and yellow. In addition, the ink supply device 4 supplies inks of the four colors to the four respective corresponding inkjet heads 31.

The operation device 801 is a device that receives a human operation. For example, the operation device 801 includes an operation button, a touch panel, and the like. The display device 802 is capable of displaying information. For example, the display device 802 includes a display panel such as a liquid-crystal panel.

### [Control Device 8]

The control device 8 executes various kinds of data processing and control over the devices included in the inkjet recording apparatus 10.

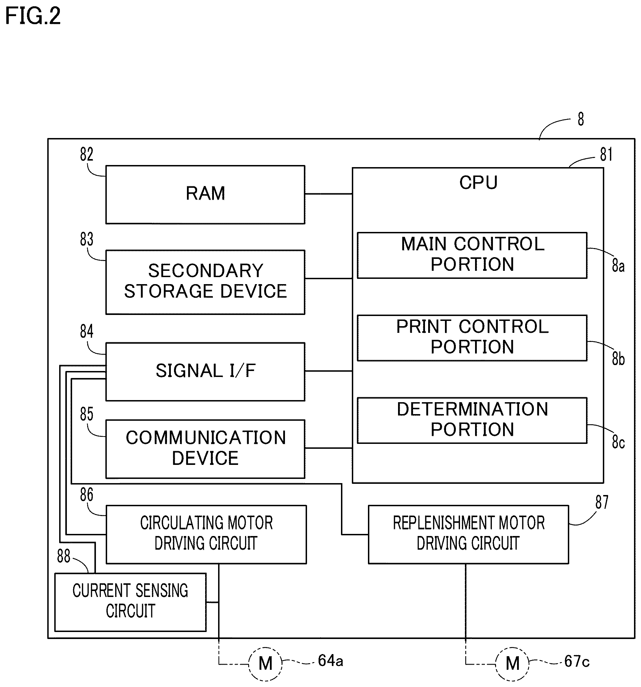

As shown in FIG. 2, the control device 8 includes a central processing unit (CPU) 81, a random access memory (RAM) 82, a secondary storage device 83, a signal interface 84, a communication device 85, and the like.

The CPU 81 is an example of a processor that executes a computer program to execute the various kinds of data processing and control.

The RAM 82 is a computer-readable volatile storage device. The RAM 82 temporarily stores the computer program that is executed by the CPU 81 and data that is output and referred to while the various kinds of processing are executed by the CPU 81.

The secondary storage device 83 is a computer-readable non-volatile storage device. The secondary storage device 83 allows the computer program and the various kinds of data to be stored and updated. For example, some or all of a flash memory, a solid state drive (SSD), and a hard disk drive are adopted as the secondary storage device 83.

The signal interface 84 converts signals that are output from various sensors to digital data and transmits the converted digital data to the CPU 81. Furthermore, the signal interface 84 converts a control instruction output from the CPU 81 to a control signal and transmits the control signal to a control target device.

The communication device 85 is capable of communicating with an unillustrated host apparatus and another apparatus. The host apparatus is an information processing apparatus such as a personal computer or a smartphone that is operated by a user.

For example, the CPU 81 receives a print job from the host apparatus through the communication device 85. The printing device 3 forms an image identified by the print job on the sheet 9.

The CPU 81 includes a plurality of processing modules implemented by executing the computer program. The plurality of processing modules includes a main control portion 8a, a print control portion 8b, and the like.

The main control portion 8a executes control of causing various processes to start in response to an operation on the operation device 801, control over the display device 802, and the like.

The print control portion 8b causes the sheet conveying device 2 to execute a sheet conveying process. Furthermore, the print control portion 8b causes the printing device 3 to execute the print process in synchronization with the conveyance of each of the sheets 9 by the sheet conveying device 2.

Incidentally, in a case where each of the inkjet heads 31 is continuously operating for a long time, the temperature of the inkjet head 31 increases.

When the temperature of each of the inkjet heads 31 increases too much, the quality of a printed image is adversely influenced. It is therefore important to cool each of the inkjet heads 31 to optimal temperature.

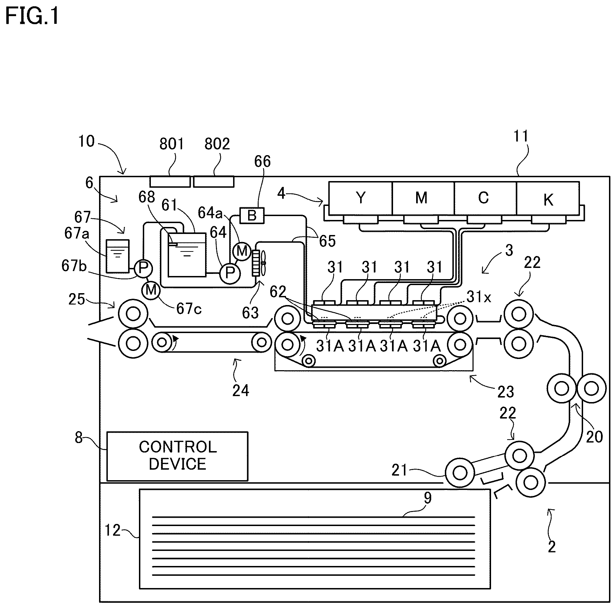

In the inkjet recording apparatus 10, the print process is increased in speed to facilitate the temperature of each of the inkjet heads 31 to further increase. The inkjet recording apparatus 10 includes a liquid-cooling device 6 to efficiently cool each of the inkjet heads 31 (see FIG. 1).

The cooling device 6 includes a main tank 61, a plurality of heat exchanging portions 62, a radiator 63, a circulating pump 64, a circulating motor 64a, and a plurality of tubes 65 (see FIG. 1). The plurality of tubes 65 connects the main tank 61, the plurality of heat exchanging portions 62, the radiator 63, and the circulating pump 64 and forms a circulation path for a liquid refrigerant.

The plurality of heat exchanging portions 62 is disposed in contact with the plurality of inkjet heads 31. The cooling device 6 circulates the liquid refrigerant in the circulation path using the circulating pump 64 to cool the plurality of inkjet heads 31. The circulation path extends through the plurality of inkjet head 31.

The main tank 61 reserves the liquid refrigerant. For example, the liquid refrigerant is water. The plurality of heat exchanging portions 62 exchanges heat between the plurality of respective inkjet heads 31 and the liquid refrigerant. The respective heat exchanging portions 62 hereby cool the inkjet heads 31 higher in temperature than the liquid refrigerant.

The radiator 63 radiates the heat of the liquid refrigerant. The circulating pump 64 circulates the liquid refrigerant in the circulation path. That is, the circulating pump 64 circulates the liquid refrigerant through the main tank 61, the plurality of heat exchanging portions 62, and the radiator 63. The circulating motor 64a drives the circulating pump 64.

The cooling device 6 further includes an air vent valve 66, a replenishment device 67, and a liquid level gauge 68. The air vent valve 66 is a valve that opens and closes an air vent opening formed in a portion of the circulation path. The air vent opening is formed at the highest portion among the plurality of tubes 65 that forms the circulation path.

The normal state of the air vent valve 66 is a closed state. The air vent valve 66 is switched from the closed state to an open state in response to an open instruction of the CPU 81.

The replenishment device 67 replenishes the main tank 61 with the liquid refrigerant. The replenishment device 67 includes an auxiliary tank 67a, a replenishment pump 67b, and a replenishment motor 67c.

The auxiliary tank 67a stores the liquid refrigerant. The replenishment pump 67b supplies the liquid refrigerant in the auxiliary tank 67a to the main tank 61. The replenishment motor 67c drives the replenishment pump 67b.

The liquid level gauge 68 detects whether the level of the liquid refrigerant in the main tank 61 reaches a reference level or falls below the reference level. When the liquid level gauge 68 detects that the level of the liquid refrigerant in the main tank 61 falls below the reference level, the replenishment motor 67c comes into operation.

In a case where the liquid-cooling device 6 is adopted, air entrainment or liquid leakage may occur in the circulation path. It is therefore important to detect the occurrence of the air entrainment and the liquid leakage and take appropriate measures such as stopping the print process.

The air entrainment and the liquid leakage typically occur as a change in the flow rate of the liquid refrigerant in the circulation path. Adopting a flowmeter that senses the flow rate of the liquid refrigerant, however, leads to increasing cost and is unpreferable.

The inkjet recording apparatus 10 includes a component that detects the air entrainment and the liquid leakage in the cooling device 6 in a simple configuration without adopting the flowmeter.

The circulating pump 64 is a centrifugal pump. The centrifugal pump is capable of circulating the liquid refrigerant at a high rate with relatively less power consumption.

In the control device 8, the plurality of processing modules of the CPU 81 further includes a determination portion 8c. In addition, the printing device 3 includes a plurality of temperature sensors 31x that senses the temperatures of the plurality of respective inkjet heads 31. For example, each of the temperature sensors 31x is a thermistor.

The determination portion 8c is an example of a determination device that determines the state of the cooling device 6. The print control portion 8b is an example of a control device that controls the plurality of inkjet heads 31 and the cooling device 6.

The control device 8 further includes a circulating motor driving circuit 86, a replenishment motor driving circuit 87, and a current sensing circuit 88 (see FIG. 2). The circulating motor driving circuit 86 supplies the circulating motor 64a with the amount of power compliant with a power supply instruction of the print control portion 8b. The replenishment motor driving circuit 87 supplies the replenishment motor 67c with power in response to a replenishment instruction of the print control portion 8b.

The print control portion 8b uses feedback control based on a plurality of sense temperatures sensed by the plurality of temperature sensors 31x and a target temperature to control power to be supplied to the control circulating motor 64a. The print control portion 8b controls the circulating motor driving circuit 86 to control the power to be supplied to the circulating motor 64a.

For example, the print control portion 8b uses feedback control based on the representative value of the plurality of sense temperatures and the target temperature to set the amount of power supply and outputs the power supply instruction indicating the set amount of power supply to the circulating motor driving circuit 86. The representative value is, for example, the maximum value or the average value of the plurality of sense temperatures.

Furthermore, when the liquid level gauge 68 detects that the level of the liquid refrigerant in the main tank 61 falls below the reference level, the print control portion 8b outputs the replenishment instruction to the replenishment motor driving circuit 87 to bring the replenishment pump 67b into operation.

In contrast, when the liquid level gauge 68 detects that the level of the liquid refrigerant in the main tank 61 reaches the reference level, the print control portion 8b stops the replenishment instruction to the replenishment motor driving circuit 87 to bring the replenishment pump 67b to a stop.

It is noted that bringing the replenishment pump 67b into operation by bringing the replenishment motor 67c into operation is bringing the replenishment device 67 into operation. In addition, bringing the replenishment pump 67b to a stop by bringing the replenishment motor 67c to a stop is bringing the replenishment device 67 to a stop.

The current sensing circuit 88 senses a current flowing from the circulating motor driving circuit 86 to the circulating motor 64a. The current sensing circuit 88 is an example of a current sensing device.

The determination portion 8c determines whether or not the air entrainment occurs and whether or not the liquid leakage occurs in the circulation path in the cooling device 6 by comparing the current sensed by the current sensing circuit 88 and a current reference range set in advance.

When the liquid leakage occurs, the load on the centrifugal pump decreases and the current flowing to the circulating motor 64a decreases. Meanwhile, when the air entrainment occurs, the load on the centrifugal pump increases and the current flowing to the circulating motor 64a increases.

It is here assumed that the lower limit value of the current reference range is a first reference value and the upper limit value of the current reference range is a second reference value. When the sensed current falls below the first reference value, the determination portion 8c determines that the liquid leakage occurs. Meanwhile, when the sensed current exceeds the second reference value, the determination portion 8c determines that the air entrainment occurs.

For example, the determination portion 8c sets the first reference value and the second reference value in accordance with the representative value of the plurality of sense temperatures.

For example, in a case where the determination portion 8c determines the occurrence of the liquid leakage, the print control portion 8b executes emergency stop control. The emergency stop control is a process of bringing the circulating motor 64a and the replenishment motor 67c to a stop and prohibiting the print process.

Furthermore, the print control portion 8b outputs alert indicating the occurrence of the liquid leakage through one or both of the display device 802 and the communication device 85 under the emergency stop control. The display device 802 and the communication device 85 are examples of output devices that each output information.

Meanwhile, in a case where the determination portion 8c determines the occurrence of the air entrainment, the print control portion 8b executes air vent control. The print control portion 8b executes the air vent control in a situation in which the print process is not performed.

The situation in which the print process is not performed is a situation in which the plurality of inkjet heads 31 each ejects no ink. The print control portion 8b may produce the situation in which the plurality of inkjet heads 31 each ejects no ink by prohibiting the print process.

The print control portion 8b executes a process of bringing the replenishment motor 67c of the replenishment device 67 into operation, keeping the circulating motor 64a continuously operating, and opening the air vent valve 66 under the air vent control. This discharges the air in the circulation path through the air vent valve 66.

For example, the print control portion 8b brings the air vent control to an end after executing the air vent control for a time defined in advance.

The print control portion 8b may output alert indicating the occurrence of the air entrainment through one or both of the display device 802 and the communication device 85 under the air vent control.

The inkjet recording apparatus 10 is adopted, thereby making it possible to detect the air entrainment and the liquid leakage in a simple configuration without adopting the flowmeter that senses the flow rate of the liquid refrigerant.

### [Supplementary Notes of Disclosure]

The gist of the disclosure extracted from the embodiment described above will be supplementarily noted below. It is noted that the respective configurations and the respective processing functions described in the following supplementary notes can be sorted out and used in any combination.

### <Supplementary Note 1>

An inkjet recording apparatus including:
an inkjet head configured to form an image on a sheet by ejecting ink;
a cooling device including a centrifugal pump and a motor configured to drive the centrifugal pump, the cooling device being configured to cool the inkjet head by circulating a liquid refrigerant in a circulation path using the centrifugal pump, the cooling device, the circulation path extending through the inkjet head;
a current sensing device configured to sense a current flowing to the motor; and
a determination device configured to determine whether or not air entrainment and liquid leakage occur in the circulation path in the cooling device by comparing the current sensed by the current sensing device and a current reference range.

### <Supplementary Note 2>

The inkjet recording apparatus according to Supplementary Note 1, including a control device configured to control the inkjet head and the cooling device, in which
the cooling device includes a tank configured to reserve the liquid refrigerant, a replenishment device configured to replenish the tank with the liquid refrigerant, and an air vent valve configured to open and close an opening formed in a portion of the circulation path, and
in a case where the determination device determines occurrence of the air entrainment, the control device executes air vent control of bringing the replenishment device into operation, keeping the motor continuously operating, and opening the air vent valve in a situation in which the inkjet head does not eject the ink.

It is to be understood that the embodiments herein are illustrative and not restrictive, since the scope of the disclosure is defined by the appended claims rather than by the description preceding them, and all changes that fall within metes and bounds of the claims, or equivalence of such metes and bounds thereof are therefore intended to be embraced by the claims.

## Claims

1. An inkjet recording apparatus (10) comprising:
an inkjet head (31) configured to form an image on a sheet by ejecting ink;
a cooling device (6) including a centrifugal pump (64) and a motor (64a) configured to drive the centrifugal pump (64), the cooling device (6) being configured to cool the inkjet head (31) by circulating a liquid refrigerant in a circulation path using the centrifugal pump (64), the cooling device (6), the circulation path extending through the inkjet head (31);
a current sensing device (88) configured to sense a current flowing to the motor (64a); and
a determination device (8c) configured to determine whether or not air entrainment and liquid leakage occur in the circulation path in the cooling device (6) by comparing the current sensed by the current sensing device (88) and a current reference range.

2. The inkjet recording apparatus (10) according to claim 1, comprising a control device (8b) configured to control the inkjet head (31) and the cooling device (6), wherein
the cooling device (6) includes a tank (61) configured to reserve the liquid refrigerant, a replenishment device (67) configured to replenish the tank (61) with the liquid refrigerant, and an air vent valve (66) configured to open and close an opening formed in a portion of the circulation path, and
in a case where the determination device (8c) determines occurrence of the air entrainment, the control device (8b) executes air vent control of bringing the replenishment device (67) into operation, keeping the motor (64a) continuously operating, and opening the air vent valve (66) in a situation in which the inkjet head (31) does not eject the ink.
